Europäisches Patentamt

(19) European Patent Office

Office européen des brevets

(11) Publication number: **0 112 007**
**B1**

(12) **EUROPEAN PATENT SPECIFICATION**

(45) Date of publication of patent specification: **01.04.87**

(21) Application number: **83306442.1**

(22) Date of filing: **24.10.83**

(51) Int. Cl.⁴: **H 02 H 7/12,** H 02 M 1/08,
H 03 K 17/725

(54) **Gate turn-off thyristor failure detection circuit.**

(30) Priority: **30.10.82 JP 191463/82**

(43) Date of publication of application:
**27.06.84 Bulletin 84/26**

(45) Publication of the grant of the patent:
**01.04.87 Bulletin 87/14**

(84) Designated Contracting States:
**CH DE GB LI SE**

(56) References cited:
**DE-A-2 812 632**
**US-A-3 277 371**

**Toshiba Review International Edition, No. 130,
Nov.-Dec. 1980, Kawasaki (JP), pages 5 to 9**

(73) Proprietor: **Kabushiki Kaisha Toshiba
72, Horikawa-cho Saiwai-ku
Kawasaki-shi Kanagawa-ken 210 (JP)**

(72) Inventor: **Seki, Nagataka c/o Patent Division
Tokyo Shibaura Denki KK 72 Horikawa-cho
Saiwai-ku
Kawasaki-shi Kanagawa-ken Tokyo (JP)**
Inventor: **Watanabe, Yukio c/o Patent Division
Tokyo Shibaura Denki KK 72 Horikawa-cho
Saiwai-ku
Kawasaki-shi Kanagawa-ken Tokyo (JP)**
Inventor: **Koike, Shunichi c/o Patent Division
Tokyo Shibaura Denki KK 72 Horikawa-cho
Saiwai-ku
Kawasaki-shi Kanagawa-ken Tokyo (JP)**

(74) Representative: **Shindler, Nigel et al
BATCHELLOR, KIRK & EYLES 2 Pear Tree Court
Farringdon Road
London EC1R 0DS (GB)**

Description

This invention relates to a failure detecting circuit for gate-turn-off thyristors that detects short-circuit failures of gate-turn-off thyristors at their gate circuits.

DE—A—2 812 632 discloses a circuit for turning-off a gate-turn-off thyristor. Such a circuit is shown for example in Figure 6 of that document as comprising a pulse amplifier (100, 32, 35) for amplifying an off-gate signal (received at the base of transistor 32), a pulse transformer (31) having primary ($31_1$) and secondary windings ($31_2$ and $31_3$), said primary winding ($31_1$) being connected to the output of said pulse amplifier, a gate pulse synthesising circuit (1—13, 21—23, 33—34, 100—106) for producing a gate pulse which is applied to the gate (G) of a gate-turn-off thyristor (1), the input of said gate pulse synthesising circuit being connected to the secondary winding of the pulse transformer (31) (see particularly page 13, line 27 to page 17, line 19; Figure 6).

Hitherto, short-circuit failures of gate-turn-off (which are hereinafter referred to as GTO) thyristors have usually been detected by monitoring the short-circuit current or voltage drop between the anode and cathode of the GTO thyristor. However when a number of GTO thyristors are connected to each other in series, even if one of the GTO thyristors breaks down, it does not cause a short-circuit current to flow. Accordingly, the voltage across the whole serially connected assembly of GTO thyristors does not become low.

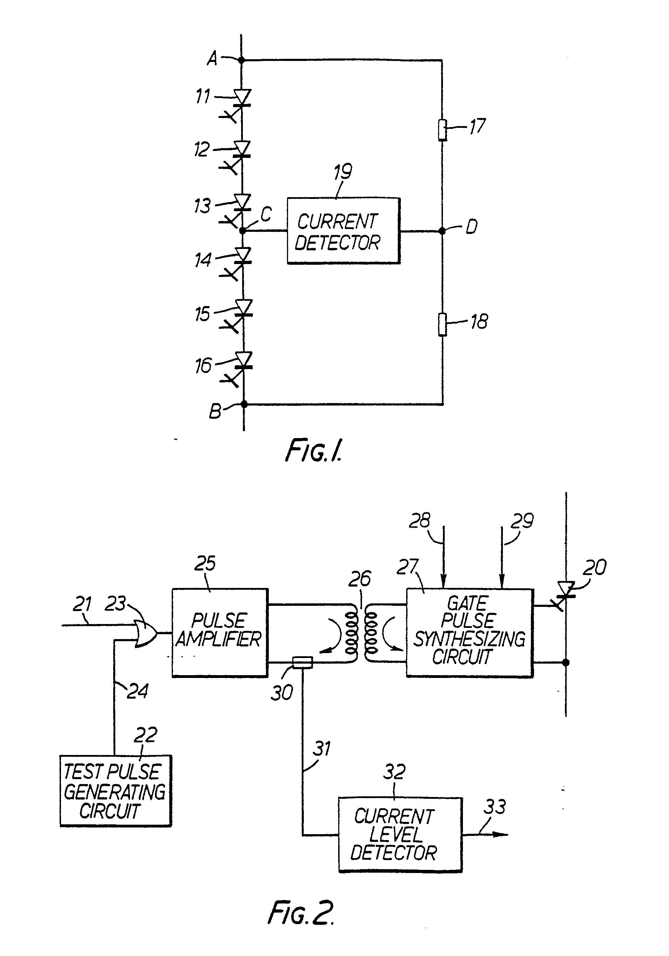

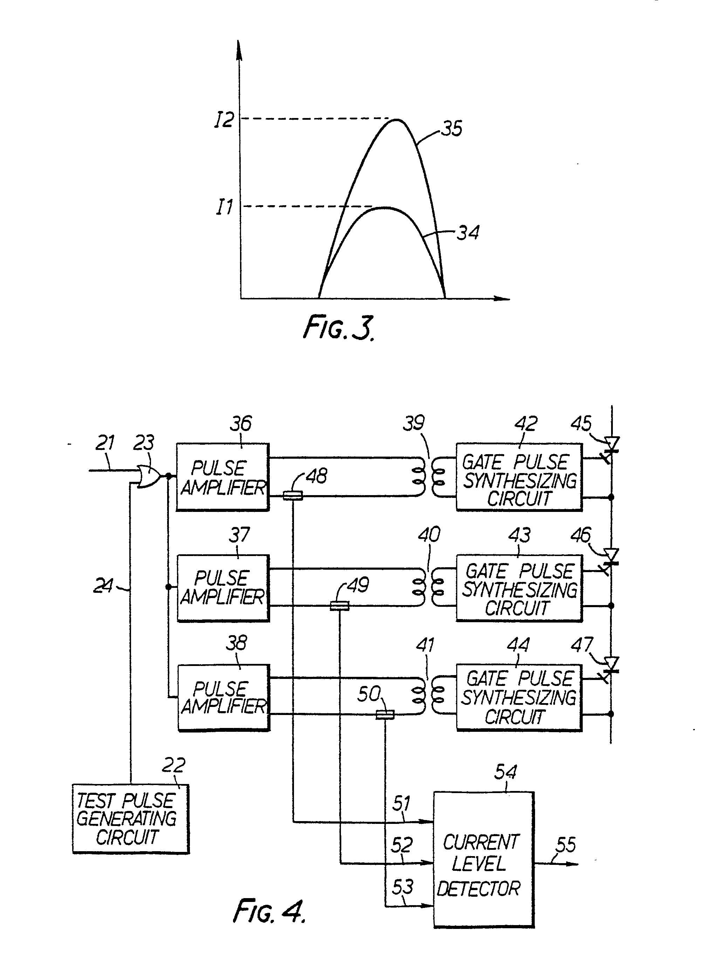

In order to detect a failure in one of the serially connected GTO thyristors, circuits of the type as shown in Figure 1 have been utilised, see for example Toshiba Review International Edition No. 130, Nov—Dec 1980, Page 6, Figure 3. In Figure 1, reference numerals 11 through 16 represent GTO thyristors. In this case, six GTO thyristors are connected in series. Reference numerals 17 and 18 represent voltage-dividing resistors, and 19 represents a current detector circuit. When all the GTO thyristors 11 through 16 are in normal operation, the voltage between points C and B is half the voltage between points A and B. Similarly, the voltage between points D and B is half of the voltage between points A and B. The potentials at points C and D are equivalent, so no current flows between points C and D.

When the GTO thyristor 11 suffers a short-circuit failure, the voltage between points C and B rises to more than half of the voltage between points A and B. Consequently, a current flows from point C to point D. If the current detector 19 detects the current that flows from point C to point D, it is judged that one of the GTO thyristors has failed. On the other hand, when GTO thyristor 14 suffers a short-circuit failure, a current flows from point D to point C and can be detected by current detector 19 to indicate, the failure of one of the GTO thyristors.

In the aforementioned conventional method, failure of a GTO thyristor element is detected by the difference between the voltage across points A and C and that across points C and B. This method has the disadvantage, however, that when the number of GTO thyristors between points A and C which suffer a short-circuit failure is equal to the number of the GTO thyristors between points C and B which have also suffered a short-circuit failure, the failure of such GTO thyristors cannot be detected by this means.

Furthermore, when the number of serialy connected GTO thyristors is large the voltage-divider resistors must have a higher breakdown voltage.

It is therefore an object of this invention to provide a GTO thyristor failure detecting circuit capable of detecting failure of the gate circuit of a GTO thyristor at the gate circuit thereof without any modifications in the main circuit, and of detecting failures that occur in series-connected GTO thyristors.

Accordingly the present invention provides a circuit for turning-off a gate-turn-off thyristor and detecting a short-circuit failure thereof comprising;

a pulse amplifier for amplyfing an off-gate signal;

a pulse transformer having primary and secondary windings, said primary winding being connected to the output of said pulse amplifier;

a gate pulse synthesising circuit for producng a gate pulse which is applied to a gate of the gate-turn-off thyristor, the input of said gate pulse synthesising circuit being connected to the secondary winding of said pulse transformer; characterised by

means for detecting current flowing through said primary winding of said pulse transformer and producing an output signal in response thereto; and

means for comparing the output signal from said detecting means with a predetermined value to produce a signal indicative of the failure of the gate-turn-off thyristor when the current in the primary winding of the pulse transformer exceeds a predetermined level.

Some embodiments of the invention will now be described by way of example with reference to the accompanying drawings in which:

Figure 1 is a schematic diagram illustrating a conventional failure detecting circuit for serially connected GTO thyristors;

Figure 2 is a block diagram illustrating one embodiment according to this invention;

Figure 3 is a characteristic diagram for explaining the principle of this invention; and

Figure 4 is a block diagram to which this invention is adapted for a circuit with a number of GTO thyristors in series connection.

One embodiment of this invention is shown in Figure 2. Referring to Figure 2, reference numeral 20 represents a GTO thyristor. An off-gate signal 21 can be applied to a pulse amplifier 25 through an OR gate circuit 23. A test pulse 24 from a test pulse generating circuit 22 can be applied to the other terminal of OR gate circuit 23. The output signal from pulse amplifier 25 is applied to a primary winding of an off-gate pulse transformer

## Patentansprüche

1. Schaltkreis zum Abschalten eines Gatter-Abschalt-Thyristors (20) zur Feststellung eines Kurzschlußfehlers darin,

— mit einem Impulsverstärker (25) zur Verstärkung eines Aus-Gatter-Signales,

— mir einem Impulstransformator (26) mit Primär- und Selundärwicklungen, wobei die Primärwicklung mit dem Ausgang des genannten Impulsverstärkers (25) verbunden ist,

— mit einer Gatter-Impuls-Synthetisierschaltung (27) zur Erzeugung eines Gattersignales, das an ein Gatter des Gatter-Abschalt-Thyristors (20) angelegt ist, wobei der Eingang der Gatter-Impuls-Synthetisierschaltung (27) mit der Sekundärwicklung des ganannten Impulstransformators (26) verbunden ist,

gekennzeichnet durch

— Mittel (30) zur Feststellung des durch die ganannte Primärwicklung des genannten Impulstransformators (26) fließenden Stromes und zur Erzeugung eines Ausgangssignales in Abhängigkeit davon, und

— Mittel (32) zum Vergleich des Ausgangssignales von den Feststellmitteln (30) mit einem vorbsetimmten Wert zur Erzeugung eines Signales, das einen Fehler des Gatter-Abschalt-Thyristors (20) anzeigt, wenn der Strom in der Primärwicklung des Impulstransformators (26) einen vorbestimmten Pegel überschreitet.

2. Schaltkreis nach Anspruch 1, gekennzeichnet durch Schaltungsmittel (22) zur Erzeugung eines Prüf-Aus-Gattersignales, wobei die erzeugenden Schaltungsmittel (22) mit dem genannten Impulsverstärker (25) verbunden sind.

## Revendications

1. Circuit pour le blocage d'un thyristor blocable (20) et la détection d'un défaut, par court-circuit, de celui-ci, comprenant:

un amplificateur d'impulsions (25) pour l'amplification d'un signal de blocage;

un transformateur d'impulsions (26), ayant des enroulements primaire et secondaire, cet enroulement primaire étant connecté à la sortie dudit amplificateur d'impulsions (25); un circuit synthétiseur d'impulsions d'électrode de commande (27) pour produire une impulsion d'électrode de commande qui est appliquée à une électrode de commande du thyristor blocable (20), l'entrée de ce circuit synthétiseur d'impulsions d'électrode de commande (27) étant connectée à l'enroulement secondaire dudit transformature d'impulsions (26); caractérisé par des moyens (30) pour détecter le courant traversant ledit enroulement primaire dudit transformateur d'impulsions (26) et pour produire un signal de sortie en réponse à ce courant; et des moyens (32) pour comparer le signal de sortie de ces moyens de détection (30) avec une valeur prédéterminée afin de produire un signal indicateur du défaut du thyristor blocable (20) lorsque le courant dans l'enroulement primaire du transformateur d'impulsions (26) dépasse un niveau prédéterminé.

2. Circuit selon la revendication 1, comprenant en outre des moyens de circuit (22) pour engendrer un signal de blocage d'essai, ces moyens de circuit générateurs (22) étant connectés audit amplificateur d'impulsions (25).

26. The off-gate pulse from a secondary winding of pulse transformer 26 -is applied to a gate pulse synthesising circuit 27. Gate pulse synthesising circuit 27 functions so as to synthesise the off-gate pulse transformer 26, an on-gate pulse for GTO thyristor 20 and a negative bias 29.

A current detector 30 detects a current flowing through the primary winding of pulse transformer 26. An output voltage signal 31 from current detector 30 is applied to a current level detector 32. Current level detector 32 compares the voltage signal 31 with a predetermined value. When the voltage signal 31 is equal to or larger than the predetermined value, current level detector 32 produces a GTO thyristor failure signal 33.

Referring to Figure 3, reference numeral 34 represents the primary current of pulse transformer 26. The primary current 34 flows through the primary windings of pulse transformer 26 when GTO thyristor 20 is in normal operation. In Figure 3, the abscissa represents time, and the ordinate current, respectively. In the normal operation, the GTO thyristor has a certain value of impedance between the gate and the cathode. When the GTO thyristor breaks down, the impedance between the gate and the cathode of the GTO thyristor becomes extremely small. In this case, the primary current of pulse transformer 26 increases as shown by the waveform 35 illustrated in Figure 3. The predetermined value of current level detector 32 is set between the peak value $I_1$ of current waveform 34 and the peak value $I_2$ of current waveform 35. In current level detector 32, the voltage signal 31 is compared with the predetermined value and the normal or failure status of the GTO thyristor can be discriminated.

In operation, before the main circuit composed of the GTO thyristors is energised, a test pulse 24 from test pulse generating circuit 22 is applied to each of the GTO thyristors in order to check them. During the operation of the main circuit, the failure of the GTO thyristor can also be instantaneously detected by applying the off-gate signal 21 to pulse amplifier 25. The off-gate current of the GTO thyristor corresponds to the magnitude of the off-gate signal flowing through primary winding of pulse transformer 26.

It is preferable that the voltage of the off-gate pulse applied to the gate of the GTO thyristor is lowered when examining the GTO thyristor. When the voltage of the off-gate pulse is set below the reverse breakdown voltage between the gate and the cathode of the GTO thyristor, the gate current in normal operation is almost negligible.

Accordingly, it is easy to discriminate whether the GTO thyristor has failed or not.

Another embodiment of the invention is shown in Figure 4 wherein similar parts as shown in Figure 2 are designated by like reference numerals.

Referring to Figure 4, reference numerals 36, 37 and 38 represent pulse amplifiers, 39, 40 and 41 represent pulse transformers, 42, 43 and 44 represent gate pulse synthesising circuit, and 45, 46 and 47 represent GTO thyristors, respectively, the respective ones of which have the identical functions with those in Figure 2. Current detectors 48, 49 and 50 convert off-gate currents of the GTO thyristors 45, 46 and 47 into respective voltage signals 51, 52 and 53. A current level detector 54 detects failures of the GTO thyristors in accordance with the magnitude of the voltage signals 51, 52 and 53 so as to produce a failure signal 55. When a failure of the individual GTO thyristor is to be detected, each of voltage signals 51, 52 and 53 is compared with the predetermined value. When failure of two or more GTO thyristors are to be detected, the level detection is performed by feeding the voltage signals 51, 52 and 53 through a maximum value select circuit such as a diode OR circuit and the maximum voltage signal is compared with the predetermined value. The level detection can be achieved by only a single circuit independent of the number of GTO thyristors, and can also be achieved in the case of parallel-connected GTO thyristors.

As described above, in accordance with this invention, without any modifications of the main circuit, and further, prior to energising the main circuit, any short-circuit failure of the GTO thyristor can be detected by virtue of the off-gate current at the gate circuit thereof. Furthermore, even when a plurality of GTO thyristors are utilised in serial or parallel connection, failure detection can be achieved merely by the addition of simple circuits.

**Claims**

1. A circuit for turning-off a gate-turn-off thyristor (20) and detecting a short circuit failure thereof comprising:

a pulse amplifier (25) for amplifying an off-gate signal;

a pulse transformer (26) having primary and secondary windings, said primary winding being connected to the output of said pulse amplifier (25);

a gate pulse synthesising circuit (27) for producing a gate pulse which is applied to a gate of the gate-turn-off thyristor (20), the input of said gate pulse synthesising circuit (27) being connected to the secondary winding of said pulse transformer (26);

characterised by

means (30) for detecting the current flowing through said primary winding of said pulse transformer (26) and producing an output signal in response thereto; and

means (32) for comparing the output signal from said detecting means (30) with a predetermined value to produce a signal indicative of the failure of the gate-turn-off thyristor (20) when the current in the primary winding of the pulse transformer (26) exceeds a predetermined level.

2. A circuit according to claim 1 further comprising circuit means (22) for generating a test off-gate signal, said generating circuit means (22) being connected to said pulse amplifier (25).

*Fig.1.*

*Fig.2.*

**0 112 007**

$I2$

$I1$

35

34

Fig. 3.

21 23    36 PULSE AMPLIFIER    48    39    42 GATE PULSE SYNTHESIZING CIRCUIT    45

24    37 PULSE AMPLIFIER    49    40    43 GATE PULSE SYNTHESIZING CIRCUIT    46

38 PULSE AMPLIFIER    50    41    44 GATE PULSE SYNTHESIZING CIRCUIT    47

22 TEST PULSE GENERATING CIRCUIT

54 CURRENT LEVEL DETECTOR    55

51 52 53

Fig. 4.

2